# EUROPEAN PATENT APPLICATION

(11) **EP 3 505 942 A1**
(43) Date of publication of application: **03.07.2019**
(21) Application number: 18215211.6
(22) Date of filing: 21.12.2018
(51) Int. Cl.: G01R 15/24, G01R 29/08, G01R 31/308, G01R 31/317

(54) **LARGE DYNAMIC RANGE ELECTRO-OPTIC PROBE**

(30) Priority: 31.12.2017 US 201715859596
(71) Applicant: Tektronix, Inc., Beaverton, OR 97077-0001 (US)
(72) Inventor: MENDE, Michael, Portland, Oregon 97229 (US); KNIERIM, Daniel, Beaverton, Oregon 97008 (US); BOOMAN, Richard, Lake Oswego, Oregon 97034 (US)
(74) Representative: HGF Limited

(57) **Abstract**

A mechanism is included for receiving a phase modulated optical signal. The phase modulated signal is modulated by a remote electrical test signal at a sensor head. A reference optical signal is also received. A phase difference between the phase modulated optical signal and the reference optical signal is then determined. The phase difference is employed to recover the remote electrical test signal from the sensor head. The phase difference may be determined by employing a phase modulator in a controller that tracks a phase modulator in the sensor head. The phase difference may also be determined by comparison of the signals in the complex signal domain.

## Description

### FIELD OF THE INVENTION

This disclosure is directed to a system and methods for testing electrical signals, and, more particularly, to an electro-optical voltage probe and corresponding accessory for use in conjunction with a test and measurement instrument such as an oscilloscope.

### BACKGROUND

Test and measurement systems are designed to receive signals, sample the signals, and display the results. For example, a test and measurement system may be implemented to determine and display characteristics of signals occurring at a device under test (DUT). In some cases, the test and measurement system may be electrically isolated from the DUT. For example, some DUT signals may be altered by the presence of electrical fields in close proximity to the DUT. In such cases, the test and measurement system may employ optical signals to enforce an electrical isolation barrier between the test and measurement system and the DUT. Such systems may be limited to a small usable voltage range due to the nature of the transfer function of associated electro-optical components.

Aspects of the invention address these and other issues.

### BRIEF DESCRIPTION OF THE DRAWINGS

Fig. 1 is a schematic diagram of an example test and measurement system employing an electro-optic probe, according to embodiments of the disclosed technology.
Fig. 2 is a schematic diagram of an example test and measurement system employing an electro-optic probe with an external optical reference connection for environmental noise mitigation, according to embodiments of the disclosed technology.
Fig. 3 is a schematic diagram of an example test and measurement system employing an electro-optic probe configured for differential phase modulation, according to embodiments of the disclosed technology.
Fig. 4 is a schematic diagram of an example test and measurement system configured to generate a reference signal at a sensor head, according to embodiments of the disclosed technology.
Fig. 5 is a schematic diagram of an example test and measurement system employing a power monitor for environmental optical intensity variance mitigation, according to embodiments of the disclosed technology.
Fig. 6 is a schematic diagram of an example of another test and measurement system configured for signal phase comparison in the complex signal domain, according to embodiments of the disclosed technology.
Fig. 7 is a flowchart of an example method for determining a phase difference between a phase modulated optical signal and a reference optical signal to recover a remote electrical test signal from a sensor head, according to embodiments of the disclosed technology.

### DETAILED DESCRIPTION

Electro-optical test systems employ phase modulation to measure voltage changes. Phase modulation includes altering an optical transmission signal relative to an optical reference signal. The two signals are then recombined into an amplitude modulated output signal. Upon recombination, the modulated output signal changes due to constructive interference and/or destructive interference between the transmission signal and the reference signal. Specifically, the amplitude modulated output signal varies sinusoidally as the relative phase between the transmission signal and the reference signal changes. However, voltage in a DUT varies linearly. As such, a single linear portion of the modulated output signal may be employed to represent the voltage at the DUT. In such a case, the voltage difference between a peak and valley of the sinusoidal modulated output waveform is called a pi-voltage. It should be noted that such a scheme requires that the total voltage range for the system be limited to less than a single pi-voltage. This is because the non-linearity of the modulated signal increases as the signal approaches the pi-voltage. Due to the sinusoidal nature of the transfer function, if a pi-voltage is exceeded, an optical intensity of the output waveform could be interpreted as indicating more than one input voltage, and hence create ambiguity in the test system. This characteristic effectively limits the dynamic range of prior test systems. As a result, such systems may be limited to testing DUTs with small and well defined voltage swings (i.e. less than the peak-to-peak pi-voltage or less than plus or minus half the pi-voltage).

Disclosed herein is an electro-optical test mechanism that is not limited to a single pi-voltage, and hence provides for a significantly increased dynamic voltage range at the DUT. Specifically, an optical carrier is forwarded to a sensor head for phase modulation based on an electrical signal from the DUT. The resulting phase modulated signal is transmitted from the sensor head to a controller for comparison with a reference signal. The phase difference between the signals is employed to recover the electrical signal from the sensor head. In one example, the phase modulated signal is modulated at the sensor head by a sensor phase modulator. The phase modulated signal is then combined with the reference signal at the controller. A feedback circuit including a controller phase modulator is employed to maintain the optical output signal at a constant intensity. In such a case, the voltage employed to operate the controller phase modulator tracks the electric signal at the sensor head. In another example, an optical ninety degree hybrid is employed to combine the phase modulated signal with the reference signal into a complex signal domain. The complex signal components can then be compared by a digital signal processor (DSP) at the controller to determine the phase difference between the signals, and hence determine the electrical signal at the sensor head. Additional steps may be employed to increase the accuracy of such a system. For example, the reference signal may be forwarded from the controller to the sensor head and back along with the phase modulated signal. This allows both signals to experience a common set of environmental noise, which cancels out when the signals are combined/analyzed. Further, both the phase modulated signal and the reference signal may be modulated at the sensor head to experience opposite phase shifts. This results in a differential signaling scheme that may provide additional signal fidelity for fine measurements. As yet another example, the optical carrier generated by the controller may be split into the optical test signal and the reference signal at the sensor head. This reduces variance in environmental impact on the two signals. In yet another example, a power monitor may be employed to adjust the optical transmitter to mitigate variance in optical intensity due to environmental changes. Regardless of the particular example, the resulting system is not limited by pi-voltage and can hence measure a much wider range of voltages at the DUT.

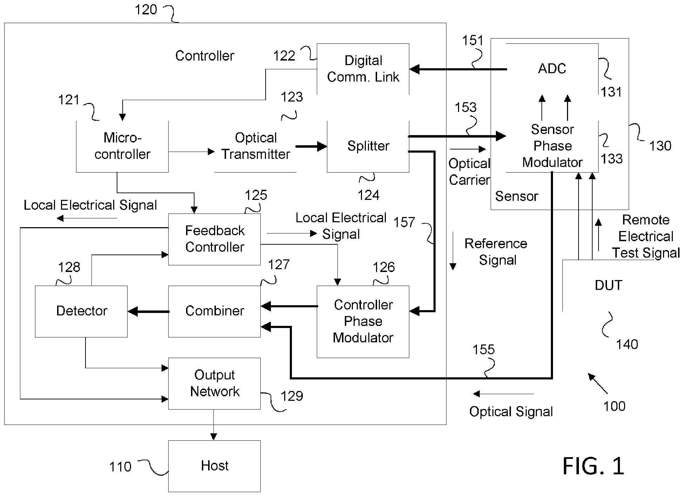

Fig. 1 is a schematic diagram of an example test and measurement system 100 employing an electro-optic probe. The system 100 includes a sensor head 130 electrically coupled to a DUT 140. The sensor head 130 is optically coupled to a controller 120, which is electrically coupled to a host 110, such as an oscilloscope. For clarity of discussion, electrical connections/traces/cables are depicted as black lines and optical connections/fibers/media are depicted as bold black lines.

The DUT 140 is any electrical device a user may wish to test. The sensor head 130 is electrically coupled to the DUT 140 to obtain an electrical signal for testing purposes, which may also be referred to as the signal under test (SUT). The electrical signal from the DUT 140 may be transmitted as a single signal or as a differential signal as depicted. The electrical signal from the DUT 140 is remote from the controller 120, and hence may be referred to herein as a remote electrical test signal. The system 100 is configured to forward the remote electrical test signal from the DUT 140 to the host 110 for testing. The host 110 may be any device configured to analyze, store, and/or display a test signal. For example, the host 110 may be an oscilloscope, a signal analyzer, or other testing equipment. A user may wish to isolate the host 110 from any electrical interference associated with the remote electrical test signal at the DUT 140. Hence, DUT 140 is coupled to the host 110 via an electro-optic probe including the controller 120 and the sensor head 130 (e.g. an electro-optical test device). Connections between the controller 120 and the sensor head 130 communicate over an optical domain and hence act as an isolation barrier preventing electricity from the sensor head/DUT side of the barrier from affecting the host 110/controller 120.

The sensor head 130 may be a low power device, such as a battery powered device, to avoid requiring a powered connection at the sensor head 130. As such, an optical carrier signal is provided by the controller 120. For example, the controller 120 may include an optical transmitter 123, which may be any device capable of generating an optical carrier (e.g. light beam), such as a laser. The optical transmitter 123 forwards the optical carrier to a splitter 124. The splitter 124 is an optical component capable of splitting an optical carrier/signal into two or more optical carriers/signals. For example, the splitter 124 may be a polarization maintaining splitter. In this case, the splitter 124 splits the optical carrier into a reference optical signal and an output optical carrier. The reference optical signal may be substantially similar to the output optical carrier (e.g. both share a common intensity etc.). The reference optical signal is forwarded over a reference connection 157. The output optical carrier is forwarded to the sensor head 130 via an optical carrier fiber 153 for phase modulation based on the remote electrical signal from the DUT 140.

The sensor head 130 receives the optical carrier from the optical carrier fiber 153. The sensor head 130 includes a sensor phase modulator 133, which is any optical device capable of modulating the phase of an optical carrier. In this case, the sensor phase modulator 133 modulates the phase of the optical carrier based on the electrical signal from the DUT 140 to create a phase modulated optical signal at the sensor head 130. The phase modulated optical signal is then returned to the controller 120 via an optical signal fiber 155. As such, the phase modulated optical signal transmits information representing the electrical signal from the DUT 140 across the optical isolation barrier. In an example, the sensor phase modulator 133 may be an integrated phase modulator with a fifty Ohm input, a bandwidth of tens of GHz, and a pi-voltage of a few Volts. In another example, the sensor phase modulator 133 may be a bulk crystal modulator with very high DC impedance (e.g. tens of giga-Ohms), a bandwidth of hundreds of megahertz (MHz) to several gigahertz (GHz), and a pi-voltage of tens to thousands of Volts depending on the geometry.

The controller 120 is configured to recover a representation of the remote electrical test signal at the sensor head and provide the representation to the host 110 for testing, measurement, and/or analysis. The controller recovers the signal by employing a combiner 127 and a feedback circuit that includes a detector 128, a feedback controller 125, and a controller phase modulator 126. The combiner 127 is an optical component that combines two or more optical signals/carriers into a single optical signal/carrier. The combiner 127 receives the reference optical signal from the reference connection 157 and the phase modulated optical signal from the optical signal fiber 155 to the sensor head 130. The combiner 127 then combines the reference optical signal and the phase modulated optical signal into a combined optical output, which is forwarded to the detector 128 of the feedback circuit.

The feedback circuit is configured to employ a local electrical signal to adjust a phase of the reference optical signal to remain in quadrature with a phase of the phase modulated optical signal from the sensor head 130. As noted above, the reference optical signal is substantially similar to the output optical carrier. Hence maintaining commensurate phase modulation on both signals is achieved by generating electrical signals operating on the optical signals. As such, a local electrical signal that modulates the phase of the reference optical signal to remain in quadrature with the phase modulated signal is effectively a representation or copy of the remote electrical test signal at the sensor head. Specifically, the detector 128 is an optical detector capable of converting an optical signal into an electrical signal. The detector 128 receives the combined optical output from the combiner 127 and provides such information to the feedback controller 125. The feedback controller 125 is any control circuit, such as a signal processor, application specific integrated circuit (ASIC), field programmable gate array (FPGA), etc. The feedback controller 125 is configured to control the controller phase modulator 126 to cause the combined optical output to remain at a substantially constant optical intensity at the detector 128. The target constant optical intensity may be chosen near a midpoint between a peak and valley of the sinusoidal transfer curve, where the amplitude sensitivity to phase change is the greatest. The controller phase modulator 126 is substantially similar to the sensor phase modulator 133, and is positioned between the reference connection 157 and the combiner 127. Accordingly, the controller phase modulator 126 modulates the phase of the reference optical signal based on a local electrical signal from the feedback controller 125. In other words, the controller phase modulator 126 adjusts the phase of the reference optical signal to be in quadrature with the phase of the phase modulated optical signal. As such, the local electrical signal applied by the feedback controller 125 to the controller phase modulator 126 matches the remote electrical signal when the reference optical signal received at the combiner 127 is in quadrature with the phase modulated signal from the sensor head 130. Stated simply, when the combined optical output is substantially constant at the detector 128, the local electrical signal provided by the feedback controller 125 to the controller phase modulator 126 tracks the remote electrical signal. Accordingly, the feedback controller 125 adjusts the controller phase modulator 126, using the local electrical signal, to maintain a constant optical intensity at the detector 128. The feedback controller 125 also provides the local electrical signal to an output network 129. The output network 129 is any communications port or other connection capable of outputting the local electrical signal to the host 110 as a recovered copy of the remote electrical test signal at the sensor head 130.

It should also be noted that, in some examples, the phase modulation may also be retained in quadrature by employing the local electrical signal to inversely phase modulate the phase modulated optical signal traversing the optical signal fiber 155. In such a case, the controller phase modulator 126 operates on the optical signal fiber 155 instead of, or in addition to, the reference connection 157 (e.g. with inverted electrical connections). Further, in some examples, detector 128 may be implemented as a balanced detector. A balanced detector monitors a difference in intensity of the signal minus the reference and a signal plus the reference. In such a case, the feedback loop matches the amplitude of the signal minus the reference and the signal plus the reference instead of keeping either amplitude constant. It should also be noted that, in some examples, the feedback circuit employs a residual error signal in conjunction with the local electrical signal to support recovering the copy of the remote electrical test signal. The residual error signal is forwarded from the detector 128 to the output network 129. The residual error signal includes intensity variation that represents the high-frequency components of the phase modulation not tracked by the feedback circuit. Such high frequency components may operate too quickly to be determined by the feedback circuit. Such residual high frequency components may still be indicative of the remote electrical test signal and may be determined by the detector as long as the high frequency components remain within the pi-voltage limits. The residual error signal may be forwarded to the host 110 for post processing of the recovered remote electrical signal.

By creating a local electrical signal at the controller 120 that matches the remote electrical test signal at the sensor 130 in this manner, the test and measurement system 100 is not limited to a portion of a pi-voltage when representing voltage from the DUT 140. Further, the described mechanism also allows for specific levels of attenuation of the signal under test. For example, a DUT 140 electrical signal (e.g. at 1000 V) may exceed the voltage measurable at the host 110 (e.g. max 100 V). Applying a consistent gain/attenuation, such one to one (1:1), ten to one (10:1), one hundred to one (100:1), one thousand to one (1000:1), etc., allows the DUT 140 electrical signal to be represented at the host 110. However, the remote electrical test signal at the sensor head 130 may be attenuated when generating the local electrical signal at the controller 120. Such attenuation occurs based on a ratio of the sensor phase modulator 133 pi-voltage to the controller phase modulator 126 pi-voltage. Accordingly, the ratio of the pi-voltage of the sensor phase modulator 133 to the pi-voltage of the controller phase modulator 126 sets an attenuation between the remote electrical test signal at the sensor head 130 and the local electrical signal employed as the recovered copy of the remote electrical test signal.

System 100 also employs various mechanisms to reduce the impact of environmental noise on the test signal. Specifically, the sensor head 130 may include a monitoring circuit that monitors for environmental changes and communicates such changes to the controller 120. The controller 120 may then remove the environmental noise from the recovered remote electrical test signal (i.e. the local electrical signal). For example, the sensor head 130 may include sensors that monitor the input and/or output of the sensor phase modulator 133 and provide such data to an analog to digital converter (ADC) 131. The ADC 131 may be a low frequency ADC and may monitor the input signal from the DUT 140 up to several tens of kilohertz (kHz). The data forwarded to the ADC 131 may act as an indication of the input signal in the absence of environmental noise. The indication of the input signal may be converted into digital form by the ADC 131 and communicated to the controller 120 over a digital communication fiber 151. For example, the sensor head 130 may include a light emitting diode (LED) or other optical source to communicate the indication of the input signal over the digital communication fiber 151. The controller 120 may compare the digitized version of the input signal to the version recovered from the feedback controller 125. The digitized version of the input signal and the version recovered from the feedback controller 125 may be combined to provide a version of the signal that excludes the environmental noise.

The controller 120 includes a digital communication link 122, which acts as a digital communication interface. The digital communication link 122 receives the indication of environmental noise and forwards such data to a microcontroller 121. A microcontroller 121 is any processing circuit capable of operating a controller 120. The micro-controller 121 may include a processor, an application specific integrated circuit (ASIC), a field programmable gate array (FPGA), digital signal processor (DSP), and/or other processing circuitry. The micro-controller 121 may also include and/or be coupled to memory, such as read only memory (RAM), random access memory (RAM), cache, flash memory, electrically erasable programmable read-only memory (EEPROM), or other memory capable of storing a computer program product for execution by the micro-controller 121. The micro-controller 121 employs the indication of environmental noise to compensate for the environmental noise. For example, the micro-controller 121 may determine that the environmental factors are creating a variance in the intensity of the optical carrier received at the sensor phase modulator 133. In such a case, the micro-controller 121 may adjust power at the optical transmitter 123 to adjust the optical carrier intensity as transmitted over the optical carrier fiber 153. This approach pre-compensates for such environmental noise. Further, the indication of environmental noise may indicate that environmental factors are creating optical phase noise that alters the signal received at the controller. In such a case, the microcontroller 121 can adjust the output of the feedback controller 125 to post-compensate for such environmental factors. This allows the microcontroller 121 to remove such environmental noise from the local electrical signal before the local electrical signal is output to the host 110 for processing and/or display to the user.

In summary, system 100 includes many advantages. For example, system 100 allows for gain dependent on a ratio of phase modulator pi-voltages. Further, the linear range of system 100 extends over many pi-voltages. Specifically, the sensor head 130 phase modulation is tracked by the controller 120 and the detector 128 output is maintained at a constant level, so input voltage level can vary over many pi-voltages. Further, the detector 128 is operated at a constant level and the input voltage is only limited by the output voltage of the feedback circuit and breakdown voltages of the modulators 126 and 133. Hence, the dynamic range is significantly improved over other optical transmission based systems

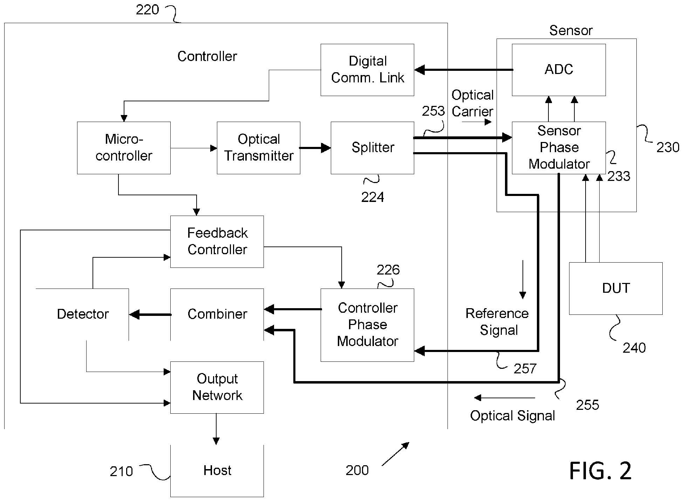

Fig. 2 is a schematic diagram of an example test and measurement system 200 employing an electro-optic probe with an external optical reference connection 257 for environmental noise mitigation. System 200 may be substantially similar to system 100. System 200 includes a host 210, a controller 220, a sensor head 230, and a DUT 240, which are substantially similar to the host 110, the controller 120, the sensor head 130, and the DUT 140, respectively. Unlike controller 120, the controller 220 employs an optical reference connection 257 that extends through the sensor head 230. For example, the optical reference connection 257 may include an optical fiber.

The controller 220 contains a splitter 224 and a controller phase modulator 226, which are substantially similar to the splitter 124 and the controller phase modulator 126, respectively. Also, the sensor head 230 contains a sensor phase modulator 233, which is substantially similar to the sensor phase modulator 133. An optical carrier is forwarded to the sensor phase modulator 233 for modulation and returned to the controller phase modulator 226 via an optical carrier fiber 253 and an optical signal fiber 255, which are similar to the optical carrier fiber 153 and the optical signal fiber 155, respectively. The optical reference connection 257 may be routed through the same casing as the optical carrier fiber 253 and the optical signal fiber 255. Accordingly, factors that alter the optical carrier or the phase modulated optical signal have a similar impact on the reference optical signal. In such a case, environmental factors may generally have a similar impact on both paths, and hence may have a reduced effect on the signal detected by the detector and the feedback circuit. Environmental factors may include temperature changes, fiber motion, etc. As such, the splitter 224 forwards the reference optical signal to the sensor head 230 to cause the reference optical signal to experience a common set of environmental factors with the phase modulated optical signal.

In both systems 100 and 200, the relative bandwidths of the feedback control circuit, the low frequency ADC, and the output network support system performance. For example, the feedback loop and ADC bandwidths may be wide enough to track and remove phase variations due to environmental factors. Further, the feedback circuit employs sufficient bandwidth to track phase changes in excess of the pi-voltage of the sensor phase modulator. If the desired test system bandwidth is greater than the feedback circuit/loop bandwidth, the feedback error signal may be routed to the output network to be combined with the lower frequency portion as captured by the feedback loop in the local electrical signal. The feedback error signal represents any higher-frequency portion of the remote electrical test signal not being tracked by the feedback loop.

Beyond the bandwidth of the feedback circuit the linear range of the systems 100 and 200 may be similar to a Mach-Zehnder based system. The bandwidth of the feedback circuit may be limited by the phase delay in the feedback path. In both of the implementations described above, the controller phase modulator should adjust the phase of the signals enough to compensate for phase changes caused by environmental factors such as temperature changes in the fiber. Since these phase changes may be quite substantial, the feedback control may also be split into two paths in some examples. For example, a first feedback control path may include a wide dynamic range and relatively low frequency response that would track the environmental changes, and a second feedback control path may be employed to track the higher speed but lower amplitude changes due to the input signal.

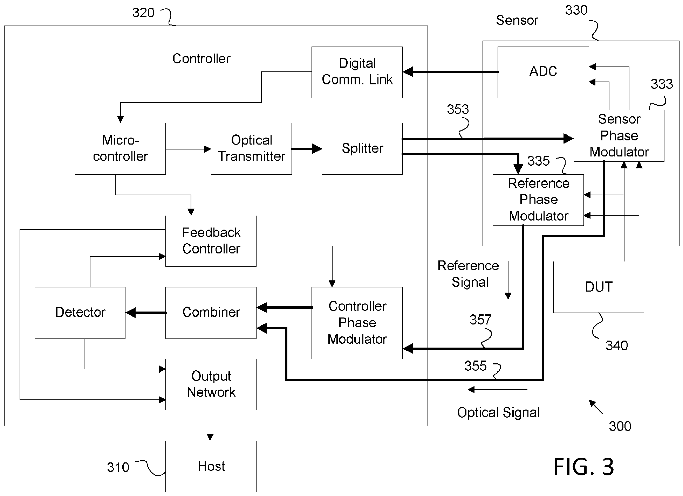

Fig. 3 is a schematic diagram of an example test and measurement system 300 employing an electro-optic probe configured for differential phase modulation. System 300 may be substantially similar to systems 100 and 200. System 300 includes a host 310, a controller 320, and a DUT 340, which are substantially similar to the host 110, the controller 120, and the DUT 140, respectively. System 300 also contains a sensor head 330, which is similar to sensor head 130, but which includes two phase modulators. Specifically, sensor head 330 includes a sensor phase modulator 333 coupled to an optical carrier fiber 353 and an optical signal fiber 355, which are substantially similar to the sensor phase modulator 133, the optical carrier fiber 153, and the optical signal fiber 155, respectively. The sensor head 330 also includes a reference phase modulator 335. The reference phase modulator 335 is similar to the sensor phase modulator 333, but is coupled along an optical reference connection 357. The optical reference connection 357 is otherwise substantially similar to the optical reference connection 257.

The sensor phase modulator 333 and the reference phase modulator 335 both receive the remote electrical test signal, but are connected to the DUT 340 by opposite polarity signals. Hence, the reference phase modulator 335 phase modulates the reference optical signal to produce a phase modulated reference signal 357. Further, the sensor phase modulator 333 phase modulates the optical carrier to produce the phase modulated optical signal 355. However, the reference optical signal and the optical carrier are modulated, at the sensor head 330, to receive an equal and opposite phase shift. The remote electrical test signal is represented by the difference between the phase modulated reference optical signal 357 and the phase modulated optical signal 355. Hence, modulating both signals in equal and opposite phase directions encodes the remote electrical test signal in finer detail. This may result in an effective amplification of the remote electrical test signal for transmission to the controller 320.

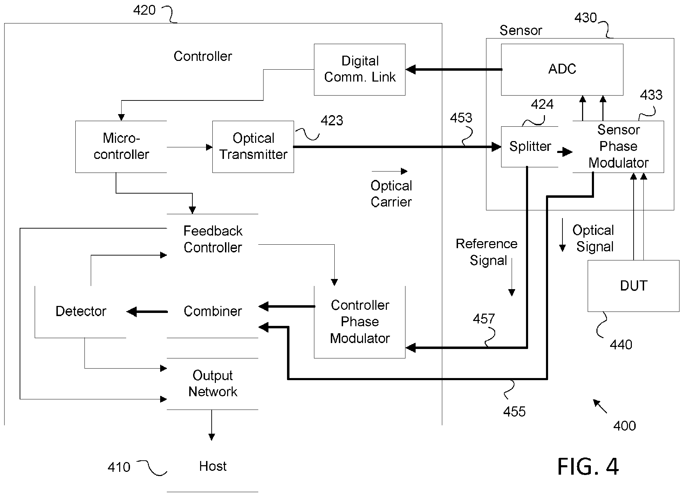

Fig. 4 is a schematic diagram of an example test and measurement system 400 configured to generate a reference signal at a sensor head 430. System 400 may be substantially similar to systems 100, 200, and 300. System 400 includes a host 410, a controller 420, a sensor head 430, and a DUT 440, which are substantially similar to the host 110, the controller 120, the sensor head 130, and the DUT 140, respectively. System 400 contains a splitter 424, which is similar to splitter 124. However, splitter 424 is located in the sensor head 430 rather than in the controller 420. Accordingly, an optical transmitter 423, which is similar to optical transmitter 123, generates an optical carrier. The optical carrier is transmitted over an optical carrier fiber 453 for splitting at the sensor head 430. The optical carrier is split into a reference optical signal, which is forwarded along an optical reference connection 457. The rest of the optical carrier is modulated into a phase modulated optical signal by a sensor phase modulator 433, which is substantially similar to the sensor phase modulator 133.

By moving the splitter 424 to the sensor head 430, the area where the reference optical signal can experience different environmental factors then the phase modulated optical signal is reduced. The approach may result in lower environmental noise at the expense of positioning additional components, and hence increasing the size of, the sensor head 430.

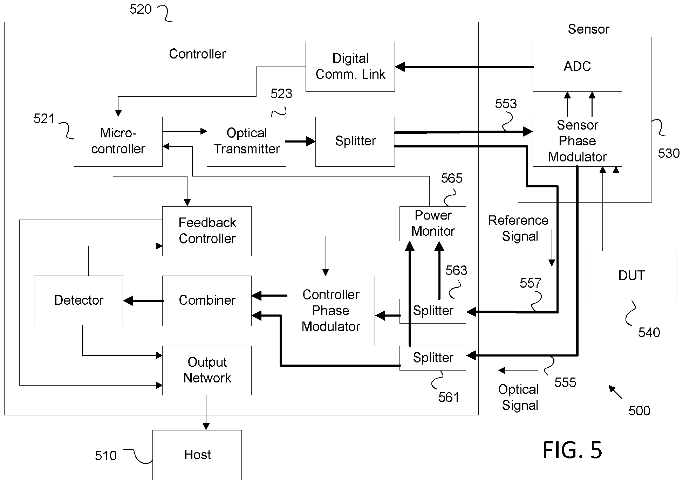

Fig. 5 is a schematic diagram of an example test and measurement system 500 employing a power monitor 565 for environmental optical intensity variance mitigation. System 500 may be substantially similar to systems 100, 200, 300, and 400. System 500 includes a host 510, a controller 520, a sensor head 530, and a DUT 540, which are substantially similar to the host 110, the controller 120, the sensor head 130, and the DUT 140, respectively. The controller 520 is coupled to the sensor head 530 by an optical reference connection 557, an optical carrier fiber 553, and an optical signal fiber 555, which are substantially similar to the optical reference connection 257, the optical carrier fiber 253, and the optical signal fiber 255, respectively.

The optical carrier, the phase modulated optical signal, and/or the reference optical signal may be dimmed or brightened if the corresponding fibers are moved. Hence, the test system environment 500 may alter the intensity of the optical signals, which may in turn be interpreted as signal noise. The controller 520 compensates for such shifts by employing a power monitor 565. A splitter 563 is positioned between the optical reference connection 557 and a controller phase modulator. A splitter 561 is also positioned between the optical signal fiber 555 and a combiner. The splitters 563 and 561 are similar to the splitter 124. The splitters 563 and 561 split a portion of the optical intensity off of the reference optical signal and the phase modulated optical signal, respectively, and forward such optical intensity to the power monitor 565. The portion of the optical intensity split to the power monitor 565 may be substantially less than the portion passed to the combiner. The power monitor 565 is configured to monitor the optical intensity of such signals for variation. The power monitor 565 outputs results to a feedback circuit which may include a microcontroller 521. The microcontroller 521 is similar to microcontroller 121. In alternate embodiments, either splitter 561 or splitter 563 may be eliminated and the optical intensity monitored on only one of the two optical signals.

The microcontroller 521 is configured to control an optical transmitter 523 that generates the optical carrier. The optical transmitter 523 may be substantially similar to optical transmitter 123. Accordingly, the microcontroller 521 is configured to adjust power to the optical transmitter and hence adjust an intensity of the optical carrier employed to create the phase modulated optical signal and the reference optical signal. The intensity may be adjusted to compensate for environmental changes in a signal path traversed by the phase modulated optical signal and the reference optical signal. For example, if both the phase modulated optical signal and the reference optical signal dim, then the microcontroller 521 can increase the intensity of the optical carrier to pre-compensate for environmental factors causing the dimming. Further, if both the phase modulated optical signal and the reference optical signal brighten, then the microcontroller 521 can reduce the intensity of the optical carrier to pre-compensate for environmental factors causing the increase in intensity.

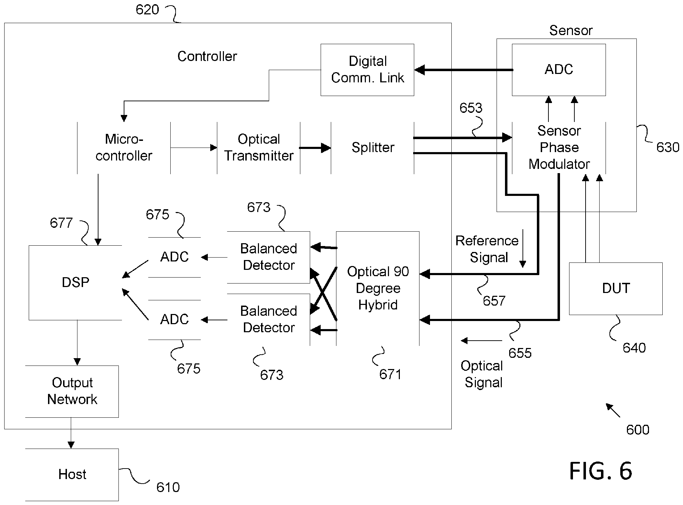

Fig. 6 is a schematic diagram of an example of another test and measurement system 600 configured for signal phase comparison in the complex signal domain. System 600 may be similar to systems 100, 200, 300, 400, and 500, but is configured to digitize the in-phase and quadrature components of the reference optical signal with respect to the phase modulated optical signal for analysis. A digital signal processor (DSP) 677 is then employed to determine the phase difference, and hence recover the remote electrical signal based on the phase difference.

System 600 includes a host 610, a sensor head 630, and a DUT 640, which may be substantially similar to host 110, sensor head 130, and DUT 140, respectively. System 600 also includes a controller 620, which is similar to controller 120. However, the analog feedback/tracking circuit is replaced by an optical 90 degree hybrid 671 and the DSP 677. The controller 620 is coupled to the sensor head 630 by an optical carrier fiber 653, an optical signal fiber 655, and a reference connection 657, which are substantially similar to the optical carrier fiber 153, the optical signal fiber 155, and the reference connection 257, respectively.

The optical 90 degree hybrid 671 is an optical component employed for coherent signal demodulation. The optical 90 degree hybrid 671 includes two input ports coupled to the optical signal fiber 655 and the reference connection 657, respectively and four output ports. The optical 90 degree hybrid 671 is configured to receive the reference optical signal and the phase modulated optical signal as modulated by the remote electrical test signal in the sensor head 630. The optical 90 degree hybrid 671 then mixes the signals into an optical output in a complex signal domain. Specifically, the optical 90 degree hybrid 671 mixes the two signal together and outputs a cosine portion of the output and a sine portion of the output. Stated another way, the optical 90 degree hybrid 671 receives the phase modulated optical signal (S) and the reference optical signal (R). The optical 90 degree hybrid 671 then provides optical output in the complex signal domain by outputting a combination of the phase modulated optical signal and the reference optical signal (S+R), a difference of the phase modulated optical signal and the reference optical signal (S-R), a combination of the phase modulated optical signal and a complex component of the reference optical signal (S+jR), and a difference of the phase modulated optical signal and the complex component of the reference optical signal (S-jR).

The optical 90 degree hybrid 671 outputs the mixed signal components into a detection circuit including two pairs of balanced detectors 673 and two ADCs 675. The balanced detectors 673 detect the components of the combined optical output and generate corresponding analog electrical signals. The ADCs 675 convert the analog electrical signals into a digital output in the complex signal domain. The ADCs 675 forward the digital output to the DSP 677. The DSP 677 is configured to employ the digital output to determine a phase difference between the phase modulated optical signal and the reference optical signal based on the digital output in the complex signal domain. For example, the DSP 677 may store the real time digital output in memory and employ signal processing algorithms to determine the phase difference between the signals over time. The DSP 677 then employs the phase difference to recover the remote electrical test signal from the sensor head 630. Specifically, the DSP 677 determines the remote electrical test signal at the sensor phase modulators that results in the determined phase difference, and saves the results as the local electrical signal. The local electrical signal can then be output, via an output network, to the host 610 for further processing. This mechanism may not include the limits imposed by the analog voltage levels employed to drive a controller phase modulator.

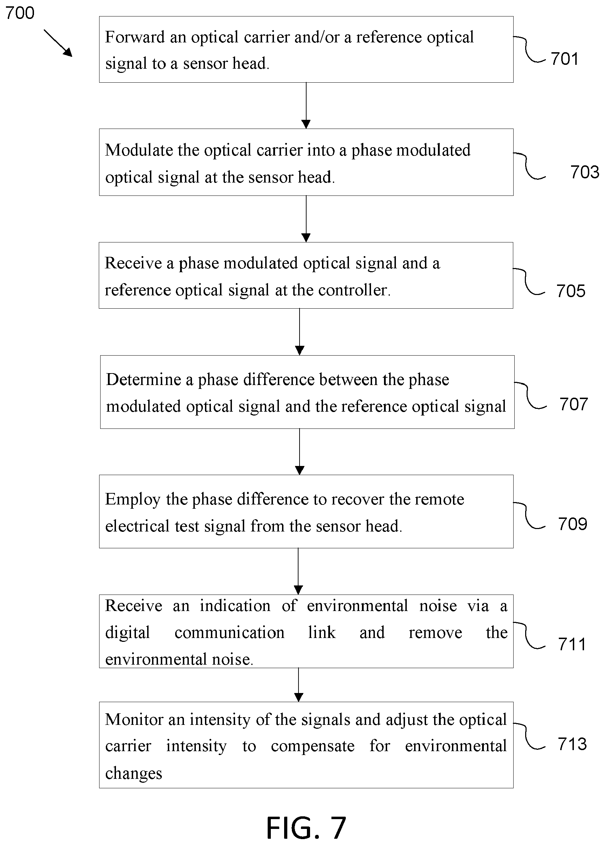

Fig. 7 is a flowchart of an example method 700 for determining a phase difference between a phase modulated optical signal and a reference optical signal to recover a remote electrical test signal from a sensor head. Method 700 may operate on electro-optic device, such as systems 100-600 or combinations thereof.

At block 701, an optical transmitter is employed to forward an optical carrier to the sensor head for phase modulation into a phase modulated optical signal based on a remote electrical test signal from a DUT. Depending on the example, a splitter may be employed to forward a reference optical signal to the sensor head to cause the reference optical signal to experience a common set of environmental factors with the phase modulated optical signal. In other examples, the optical carrier is forwarded for splitting at the sensor head into the phase modulated optical signal and the reference optical signal.

At block 703, a sensor phase modulator is employed to modulate the optical carrier to generate a phase modulated signal at the sensor head. In some examples, a reference phase modulator is also employed at the sensor head to modulate the reference optical signal. In such cases, the reference phase modulator and the sensor phase modulator are employed to cause the reference optical signal and the phase modulated signal to receive an equal and opposite phase shift. In other words, the modulators receive the same remote electrical signal at opposite polarities resulting in a differential optical signal.

At block 705, the phase modulated optical signal and the reference optical signal are received at a controller. The controller then determines a phase difference between the phase modulated optical signal and the reference optical signal at block 707. As discussed above, the phase difference may be determined in the analog domain by employing a controller phase modulator. In such a case, the phase modulated optical signal and the reference optical signal are combined into a combined optical output. A local electrical signal is then employed to phase modulate the reference optical signal to maintain the combined optical output at a substantially constant intensity. Alternatively, the local electrical signal may be employed to inversely phase modulate the phase modulated optical signal so as to cancel the phase modulation at the sensor head, and thus maintain the combined optical output at a substantially constant intensity. Hence, the local electrical signal indicates the phase difference. In such a case, the local electrical signal is applied to a controller phase modulator. As noted above, a ratio of a pi-voltage of the sensor phase modulator to a pi-voltage of the controller phase modulator sets an attenuation between the remote electrical test signal at the sensor head and a recovered electrical signal based on the remote electrical test signal.

The phase difference may also be determined in the digital domain by employing a DSP. In such a case, determining the phase difference includes employing an optical ninety degree hybrid to mix the phase modulated optical signal and the reference optical signal into an optical output in a complex signal domain. The optical output is then detected and converted into a digital signal. A DSP is then employed to determine the phase difference based on the detected optical output.

At block 709, the phase difference is employed to recover the remote electrical test signal from the sensor head. In the analog examples, the local electrical signal is used to determine the remote electrical test signal. Optionally, any residual high-frequency phase error not tracked by the feedback loop generating the local electrical signal may be added to the local electrical signal to more fully recover the remote electrical test signal. In the digital examples, an electrical signal that results in the determined phase difference is saved as a local electrical signal that tracks the remote electrical test signal.

Blocks 711 and 713 are optional blocks to reduce noise in the recovered signal. At block 711, an indication of the input signal (e.g. the remote electrical test signal) without environmental noise is received at the controller via a digital communication link. The controller then removes the environmental noise from the recovered remote electrical test signal. This can be accomplished by altering the feedback circuit in the analog systems or by altering the DSP calculations in the digital systems.

At block 713, the intensity of the phase modulated optical signal and/or the reference optical signal is monitored. A microcontroller is then employed to adjust the optical transmitter, and hence adjust the intensity of an optical carrier employed to create the phase modulated optical signal and the reference optical signal. The intensity is adjusted to compensate for environmental changes in signal paths traversed by the phase modulated optical signal and the reference optical signal.

Examples of the disclosure may operate on a particularly created hardware, on firmware, digital signal processors, or on a specially programmed general purpose computer including a processor operating according to programmed instructions. The terms "controller" or "processor" as used herein are intended to include microprocessors, microcomputers, ASICs, and dedicated hardware controllers. One or more aspects of the disclosure may be embodied in computer-usable data and computer-executable instructions, such as in one or more program modules, executed by one or more computers (including monitoring modules), or other devices. Generally, program modules include routines, programs, objects, components, data structures, etc. that perform particular tasks or implement particular abstract data types when executed by a processor in a computer or other device. The computer executable instructions may be stored on a non-transitory computer readable medium such as a hard disk, optical disk, removable storage media, solid state memory, RAM, etc. As will be appreciated by one of skill in the art, the functionality of the program modules may be combined or distributed as desired in various examples. In addition, the functionality may be embodied in whole or in part in firmware or hardware equivalents such as integrated circuits, field programmable gate arrays (FPGA), and the like. Particular data structures may be used to more effectively implement one or more aspects of the disclosure, and such data structures are contemplated within the scope of computer executable instructions and computer-usable data described herein.

Aspects of the present disclosure operate with various modifications and in alternative forms. Specific aspects have been shown by way of example in the drawings and are described in detail herein below. However, it should be noted that the examples disclosed herein are presented for the purposes of clarity of discussion and are not intended to limit the scope of the general concepts disclosed to the specific examples described herein unless expressly limited. As such, the present disclosure is intended to cover all modifications, equivalents, and alternatives of the described aspects in light of the attached drawings and claims.

References in the specification to embodiment, aspect, example, etc., indicate that the described item may include a particular feature, structure, or characteristic. However, every disclosed aspect may or may not necessarily include that particular feature, structure, or characteristic. Moreover, such phrases are not necessarily referring to the same aspect unless specifically noted. Further, when a particular feature, structure, or characteristic is described in connection with a particular aspect, such feature, structure, or characteristic can be employed in connection with another disclosed aspect whether or not such feature is explicitly described in conjunction with such other disclosed aspect.

The disclosed aspects may be implemented, in some cases, in hardware, firmware, software, or any combination thereof. The disclosed aspects may also be implemented as instructions carried by or stored on one or more or non-transitory computer-readable media, which may be read and executed by one or more processors. Such instructions may be referred to as a computer program product. Computer-readable media, as discussed herein, means any media that can be accessed by a computing device. By way of example, and not limitation, computer-readable media may comprise computer storage media and communication media.

Computer storage media means any medium that can be used to store computer-readable information. By way of example, and not limitation, computer storage media may include Random Access Memory (RAM), Read Only Memory (ROM), Electrically Erasable Programmable Read-Only Memory (EEPROM), flash memory or other memory technology, Compact Disc Read Only Memory (CD-ROM), Digital Video Disc (DVD), or other optical disk storage, magnetic cassettes, magnetic tape, magnetic disk storage or other magnetic storage devices, and any other volatile or nonvolatile, removable or non-removable media implemented in any technology. Computer storage media excludes signals per se and transitory forms of signal transmission.

Communication media means any media that can be used for the communication of computer-readable information. By way of example, and not limitation, communication media may include coaxial cables, fiber-optic cables, air, or any other media suitable for the communication of electrical, optical, Radio Frequency (RF), infrared, acoustic or other types of signals.

Illustrative examples of the technologies disclosed herein are provided below. An embodiment of the technologies may include any one or more, and any combination of, the examples described below.
Example 1 includes a method comprising: receiving a phase modulated optical signal, the phase modulated signal modulated by a remote electrical test signal at a sensor head; receiving a reference optical signal; determining a phase difference between the phase modulated optical signal and the reference optical signal; and employing the phase difference to recover the remote electrical test signal from the sensor head.
Example 2 includes the method of Example 1, wherein the phase difference between the phase modulated optical signal and the reference optical signal is determined by: combining the phase modulated optical signal and the reference optical signal into a combined optical output; and employing a local electrical signal to phase modulate the reference optical signal and/or inversely phase modulate the phase modulated optical signal in a feedback circuit monitoring the combined optical output, the local electrical signal indicating the phase difference.
Example 3 includes the method of any of Examples 1-2, further comprising employing residual error in the feedback circuit to indicate the phase difference.
Example 4 includes the method of any of Examples 1-3, further comprising: receiving an indication of the remote electrical test signal in the absence of environmental noise via a digital communication link; and removing the environmental noise from the recovered remote electrical test signal.
Example 5 includes the method of any of Examples 1-4, further comprising: forwarding an optical carrier to the sensor head for phase modulation into the phase modulated optical signal; and forwarding the reference optical signal to the sensor head to cause the reference optical signal to experience a common set of environmental factors with the phase modulated optical signal.
Example 6 includes the method of any of Examples 1-4, further comprising forwarding an optical carrier for splitting, at the sensor head, into the phase modulated optical signal and the reference optical signal.
Example 7 includes the method of any of Examples 1-6, further comprising: employing a sensor phase modulator at the sensor head to generate the phase modulated optical signal; and employing a controller phase modulator to determine the phase difference, wherein a ratio of a pi-voltage of the sensor phase modulator to a pi-voltage of the controller phase modulator sets an attenuation between the remote electrical test signal at the sensor head and a recovered electrical signal based on the remote electrical test signal.
Example 8 includes the method of any of Examples 1-7, further comprising: employing a sensor phase modulator to modulate an optical carrier at the sensor head to generate the phase modulated signal; and employing a reference phase modulator at the sensor head to modulate the reference optical signal, the reference optical signal and the phase modulated signal receiving an opposite phase shift.
Example 9 includes the method of any of Examples 1-8, further comprising: monitoring an intensity of the phase modulated optical signal and/or an intensity of the reference optical signal; and adjusting an intensity of an optical carrier employed to create the phase modulated optical signal and the reference optical signal, the intensity adjusted to compensate for environmental changes in a signal path traversed by the phase modulated optical signal and the reference optical signal.
Example 10 includes the method of any of Examples 1, 3-6, and 9, wherein determining the phase difference between the phase modulated optical signal and the reference optical signal includes: employing an optical ninety degree hybrid to mix the phase modulated optical signal and the reference optical signal into an optical output in a complex signal domain; detecting the optical output; and employing a digital signal processor to determine the phase difference based on the detected optical output.
Example 11 includes an electro-optical test device comprising: a combiner to combine a reference optical signal and a phase modulated optical signal into combined optical output, the phase modulated optical signal modulated by a remote electrical test signal in a sensor head; and a feedback circuit to: employ a local electrical signal to adjust a phase of the reference optical signal and/or a phase of the phase modulated optical signal based on an amplitude of the combined optical output; and output the local electrical signal as a recovered copy of the remote electrical test signal at the sensor head.
Example 12 includes the electro-optical test device of Example 11, further comprising: an optical transmitter to generate an optical carrier; and a splitter to split the optical carrier into the reference optical signal and an output optical carrier for phase modulation into the phase modulated optical signal at the sensor head.
Example 13 includes the electro-optical test device of any of Examples 11-12, wherein the splitter forwards the reference optical signal to the sensor head to cause the reference optical signal to experience a common set of environmental factors with the phase modulated optical signal.
Example 14 includes the electro-optical test device of any of Examples 11 and 13, further comprising an optical transmitter to generate an optical carrier for splitting, at the sensor head, into the phase modulated optical signal and the reference optical signal.
Example 15 includes the electro-optical test device of any of Examples 11-14, further comprising: a power monitor to monitor an intensity of the phase modulated optical signal and/or the reference optical signal, wherein the feedback circuit is further configured to adjust an intensity of an optical carrier employed to create the phase modulated optical signal and the reference optical signal, the intensity adjusted to compensate for environmental changes in a signal path traversed by the phase modulated optical signal and the reference optical signal.
Example 16 includes the electro-optical test device of any of Examples 11-15, wherein the reference optical signal and the phase modulated optical signal are modulated at the sensor head to receive an opposite phase shift.
Example 17 includes the electro-optical test device of any of Examples 11-16, wherein the phase modulated optical signal is modulated at the sensor head by a sensor phase modulator, the feedback circuit includes a controller phase modulator to adjust the phase of the reference optical signal and/or the phase of the phase modulated optical signal, and a ratio of a pi-voltage of the sensor phase modulator to a pi-voltage of the controller phase modulator sets an attenuation between the remote electrical test signal at the sensor head and the local electrical signal employed as the recovered copy of the remote electrical test signal.
Example 18 includes the electro-optical test device of any of Examples 11-17, wherein the feedback circuit combines a residual error signal with the local electrical signal in outputting a recovered copy of the remote electrical test signal.
Example 19 includes an electro-optical test device comprising: an optical ninety degree hybrid to mix a reference optical signal and a phase modulated optical signal into an optical output in a complex signal domain, the phase modulated optical signal modulated by a remote electrical test signal in a sensor head; a detection circuit to convert the optical output into a digital output in the complex signal domain; and a digital signal processor to: determine a phase difference between the phase modulated optical signal and the reference optical signal based on the digital output in the complex signal domain; and employ the phase difference to recover the remote electrical test signal from the sensor head.
Example 20 includes the electro-optical test device of Example 19, wherein the optical output in the complex signal domain includes a combination of the phase modulated optical signal and the reference optical signal, a difference of the phase modulated optical signal and the reference optical signal, a combination of the phase modulated optical signal and a complex component of the reference optical signal, and a difference of the phase modulated optical signal and the complex component of the reference optical signal.
Example 21 includes the electro-optical test device of any of Examples 18-20, further comprising: an optical transmitter to generate an optical carrier; and a splitter to split the optical carrier into the reference optical signal and an output optical carrier for phase modulation into the phase modulated optical signal at the sensor head.
The previously described versions of the disclosed subject matter have many advantages that were either described or would be apparent to a person of ordinary skill. Even so, all of these advantages or features are not required in all versions of the disclosed apparatus, systems, or methods.
Additionally, this written description makes reference to particular features. It is to be understood that the disclosure in this specification includes all possible combinations of those particular features. For example, where a particular feature is disclosed in the context of a particular aspect, that feature can also be used, to the extent possible, in the context of other aspects.
Also, when reference is made in this application to a method having two or more defined steps or operations, the defined steps or operations can be carried out in any order or simultaneously, unless the context excludes those possibilities.
Although specific aspects of the invention have been illustrated and described for purposes of illustration, it will be understood that various modifications may be made without departing from the scope of the invention. Accordingly, the invention should not be limited except as by the appended claims.

## Claims

1. A method comprising:
receiving a phase modulated optical signal, the phase modulated signal modulated by a remote electrical test signal at a sensor head;
receiving a reference optical signal;
determining a phase difference between the phase modulated optical signal and the reference optical signal; and
employing the phase difference to recover the remote electrical test signal from the sensor head.

2. The method of claim 1, wherein the phase difference between the phase modulated optical signal and the reference optical signal is determined by:
combining the phase modulated optical signal and the reference optical signal into a combined optical output; and
employing a local electrical signal to phase modulate the reference optical signal and/or inversely phase modulate the phase modulated optical signal in a feedback circuit monitoring the combined optical output, the local electrical signal indicating the phase difference; and optionally
further comprising employing residual error in the feedback circuit to indicate the phase difference.

3. The method of claim 1 or 2, further comprising:
receiving an indication of the remote electrical test signal without environmental noise via a digital communication link; and
removing the environmental noise from the recovered remote electrical test signal.

4. The method of any of claims 1 to 3, further comprising:
forwarding an optical carrier to the sensor head for phase modulation into the phase modulated optical signal; and
forwarding the reference optical signal to the sensor head to cause the reference optical signal to experience a common set of environmental factors with the phase modulated optical signal.

5. The method of any of claims 1 to 4, further comprising forwarding an optical carrier for splitting, at the sensor head, into the phase modulated optical signal and the reference optical signal.

6. The method of any of claims 2 to 5, further comprising:
employing a sensor phase modulator at the sensor head to generate the phase modulated optical signal; and
employing a controller phase modulator to determine the phase difference, wherein a ratio of a pi-voltage of the sensor phase modulator to a pi-voltage of the controller phase modulator sets an attenuation between the remote electrical test signal at the sensor head and a recovered electrical signal based on the remote electrical test signal.

7. The method of any of claims 1 to 6, further comprising:
employing a sensor phase modulator to modulate an optical carrier at the sensor head to generate the phase modulated signal; and
employing a reference phase modulator at the sensor head to modulate the reference optical signal, the reference optical signal and the phase modulated signal receiving an opposite phase shift.

8. The method of any of claims 1 to 7, further comprising:
monitoring an intensity of the phase modulated optical signal or an intensity of the reference optical signal; and
adjusting an intensity of an optical carrier employed to create the phase modulated optical signal and the reference optical signal, the intensity adjusted to compensate for environmental changes in a signal path traversed by the phase modulated optical signal and the reference optical signal; and/or
wherein determining the phase difference between the phase modulated optical signal and the reference optical signal includes:
employing an optical ninety degree hybrid to mix the phase modulated optical signal and the reference optical signal into an optical output in a complex signal domain;
detecting the optical output; and
employing a digital signal processor to determine the phase difference based on the detected optical output.

9. An electro-optical test device comprising:
a combiner to combine a reference optical signal and a phase modulated optical signal into a combined optical output, the phase modulated optical signal modulated by a remote electrical test signal in a sensor head; and
a feedback circuit to:
employ a local electrical signal to adjust a phase of the reference optical signal and/or a phase of the phase modulated optical signal based on an amplitude of the combined optical output; and
output the local electrical signal as a recovered copy of the remote electrical test signal at the sensor head.

10. The electro-optical test device of claim 9, further comprising:
an optical transmitter to generate an optical carrier; and
a splitter to split the optical carrier into the reference optical signal and an output optical carrier for phase modulation into the phase modulated optical signal at the sensor head; and optionally
wherein the splitter forwards the reference optical signal to the sensor head to cause the reference optical signal to experience a common set of environmental factors with the phase modulated optical signal.

11. The electro-optical test device of claim 9 or 10, further comprising an optical transmitter to generate an optical carrier for splitting, at the sensor head, into the phase modulated optical signal and the reference optical signal; and/or
a power monitor to monitor an intensity of the phase modulated optical signal and/or the reference optical signal, wherein the feedback circuit is further configured to adjust an intensity of an optical carrier employed to create the phase modulated optical signal and the reference optical signal, the intensity adjusted to compensate for environmental changes in a signal path traversed by the phase modulated optical signal and the reference optical signal.

12. The electro-optical test device of any of claims 9 to 11, wherein the reference optical signal and the phase modulated optical signal are modulated at the sensor head to receive an opposite phase shift: and/or
wherein the phase modulated optical signal is modulated at the sensor head by a sensor phase modulator, the feedback circuit includes a controller phase modulator to adjust the phase of the reference optical signal and/or the phase of the phase modulated optical signal, and a ratio of a pi-voltage of the sensor phase modulator to a pi-voltage of the controller phase modulator sets an attenuation between the remote electrical test signal at the sensor head and the local electrical signal employed as the recovered copy of the remote electrical test signal.

13. The electro-optical test device of any of claims 9 to 12, wherein the feedback circuit combines a residual error signal with the local electrical signal in outputting a recovered copy of the remote electrical test signal.

14. An electro-optical test device comprising:
an optical ninety degree hybrid to mix a reference optical signal and a phase modulated optical signal into an optical output in a complex signal domain, the phase modulated optical signal modulated by a remote electrical test signal in a sensor head;
a detection circuit to convert the optical output into a digital output in the complex signal domain; and
a digital signal processor to:
determine a phase difference between the phase modulated optical signal and the reference optical signal based on the digital output in the complex signal domain; and
employ the phase difference to recover the remote electrical test signal from the sensor head.

15. The electro-optical test device of claim 14, wherein the optical output in the complex signal domain includes a sum of the phase modulated optical signal and the reference optical signal, a difference of the phase modulated optical signal and the reference optical signal, a sum of the phase modulated optical signal and a complex component of the reference optical signal, and a difference of the phase modulated optical signal and the complex component of the reference optical signal; and/or
further comprising:
an optical transmitter to generate an optical carrier; and
a splitter to split the optical carrier into the reference optical signal and an output optical carrier for phase modulation into the phase modulated optical signal at the sensor head.
